# EUROPEAN PATENT APPLICATION

(11) **EP 2 824 706 A2**
(43) Date of publication of application: **14.01.2015**
(21) Application number: 14176013.2
(22) Date of filing: 07.07.2014
(51) Int. Cl.: H01L 25/04, H01L 31/0687, H01L 31/18

(54) **Adhesive bonded solar cell assembly**

(30) Priority: 08.07.2013 US 201313936592
(71) Applicant: The Boeing Company, Chicago, IL 60606-2016 (US)
(72) Inventor: Chiu, Philip, Chicago, Illinois 60606-2016 (US); Rehder, Eric M., Chicago, Illinois 60606-2016 (US)
(74) Representative: Smith, Jeremy Robert

(57) **Abstract**

A solar cell assembly including a first solar cell component, a second solar cell component, an adhesive layer positioned between the first solar cell component and the second solar cell component, and a contact extending through the adhesive layer to electrically couple the first solar cell component to the second solar cell component.

## Description

### FIELD

This application relates to wafer bonding and, more particularly, to bonding solar cell components using an adhesive.

### BACKGROUND

Solar cells convert the sun's energy into useful electrical energy by way of the photovoltaic effect. Therefore, solar cells provide a reliable, lightweight and sustainable source of electrical energy suitable for a variety of terrestrial and space applications.

Multijunction solar cells include two or more stacked cells, such as a high bandgap top cell stacked on a low bandgap bottom cell. Therefore, solar energy transmitted through the top cell may be absorbed by the bottom cell. As such, multijunction solar cells operate at efficiencies that are significantly higher than traditional solar cells, with the added advantage of being lightweight.

Multijunction solar cells are traditionally formed by epitaxial growth to yield a monolithic structure. For example, a first cell may be grown on a substrate. Then, another cell may be grown on the first cell. However, various factors, such as lattice mismatch between adjacent cells, make it difficult, and thus expensive, to manufacture certain multijunction solar cells using epitaxy.

Wafer bonding has been used as an alternative to traditional monolithic epitaxy techniques. Specifically, attempts have been made to wafer bond adjacent cells of a multijunction solar cell using direct bonding (no intermediate adhesive layer), anodic bonding (oxide-to-oxide bonding), and metal bonding. Unfortunately, in direct bonding and anodic bonding, the bond typically occurs between two non-conforming materials and, therefore, requires excellent surface roughness and a particle free surface. Metal bonds have low optical transmission and, therefore, are generally not suitable when there is an active layer (e.g., a p-n junction) below the metal bond.

Thus, there exists a need to develop a multijunction solar cell that overcomes the shortcomings of the previous multijunction solar cells described above (e.g., epitaxial growth and wafer bonding).

### SUMMARY

In one embodiment, the disclosed adhesive bonded solar cell assembly may include a first solar cell component, a second solar cell component, an adhesive layer positioned between the first solar cell component and the second solar cell component, and a contact (or a plurality of contacts) extending through the adhesive layer to electrically couple the first solar cell component to the second solar cell component.

In another embodiment, the disclosed adhesive bonded solar cell assembly may include a high bandgap solar cell, a low bandgap solar cell, an adhesive layer positioned between the high bandgap solar cell and the low bandgap solar cell, and a contact (or a plurality of contacts), wherein the contact extends through the adhesive layer to electrically couple the high bandgap solar cell to the low bandgap solar cell.

In another embodiment, the disclosed assembly may include a first wafer, a second wafer, a transparent adhesive positioned between the first wafer and the second wafer to form an adhesive layer, the adhesive having an index of refraction of at most 1.6, and a contact (or a plurality of contacts), wherein the contact extends through the adhesive layer to electrically couple the first wafer to the second wafer.

In yet another embodiment, disclosed is a method for manufacturing a solar cell assembly. The method may include the steps of (1) providing a first solar cell component and a second solar cell component; (2) forming an adhesive layer; (3) forming a contact that extends through the adhesive layer; and (4) bonding the first solar cell component to the second solar cell component with the adhesive layer.

Other embodiments of the disclosed adhesive bonded solar cell assembly will become apparent from the following detailed description, the accompanying drawings and the appended claims.

### BRIEF DESCRIPTION OF THE DRAWINGS

Fig. 1 is a schematic cross-sectional view of one embodiment of the disclosed adhesive bonded solar cell assembly;
Fig. 2 is a schematic cross-sectional view of another embodiment of the disclosed adhesive bonded solar cell assembly;
Fig. 3 is a schematic cross-sectional view of yet another embodiment of the disclosed adhesive bonded solar cell assembly;
Fig. 4 is a graphical representation of the transmission spectra of the adhesive bonded solar cell assemblies of Figs. 1-3;
Fig. 5 is a graphical representation of reflectance at 870 nm for light exiting the top component as a function of angle of incidence for the adhesive bonded solar cell assembly of Fig. 1; and
Fig. 6 is a flow chart illustrating one embodiment of the disclosed method for manufacturing a solar cell assembly.

### DETAILED DESCRIPTION

The following description refers to solar cells and, specifically, to adhesive bonding solar cell components. However, those skilled in the art will appreciate that the disclosed adhesive bonding techniques may be used to form various wafer-to-wafer bonds without departing from the scope of the present disclosure.

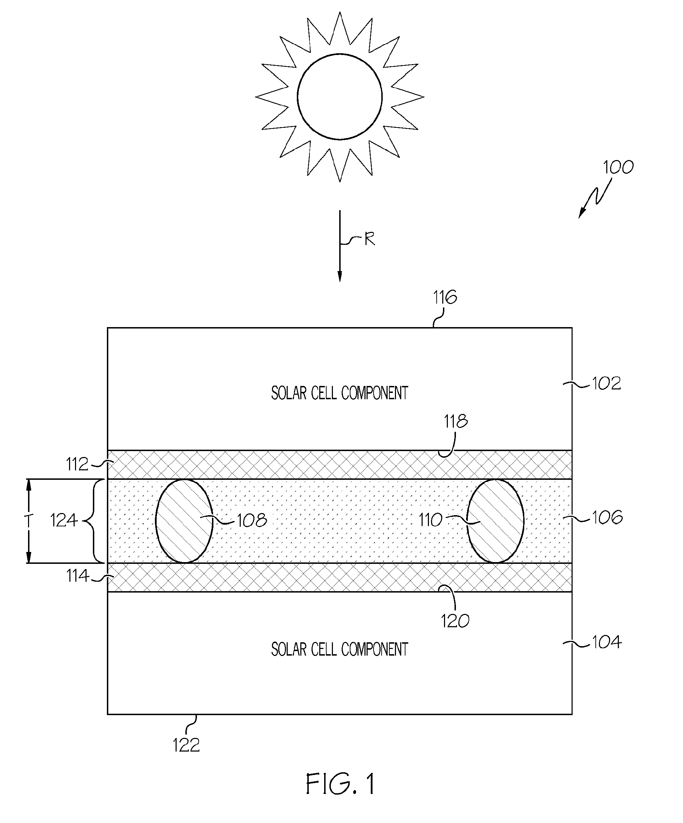

Referring to Fig. 1, one embodiment of the disclosed adhesive bonded solar cell assembly, generally designated 100, may include a first solar cell component 102, a second solar cell component 104, an adhesive 106, and contacts 108, 110. Additionally, a first conductive interface layer 112 may be applied to the first solar cell component 102 and/or a second conductive interface layer 114 may be applied to the second solar cell component 104.

The first solar cell component 102 may be any component, whether active (e.g., contains one or more p-n junctions) or inactive (does not contain a p-n junction), of a solar cell stack. As one general example, the first solar cell component 102 may be a solar subcell, and may include one p-n junction, two p-n junctions or three or more p-n junctions. In other words, the first solar cell component 102 may be a single junction solar cell or a multijunction solar cell. As one specific, non-limiting example, the first solar cell component 102 may be a high bandgap (about 1.4 and about 2.2 eV) multijunction solar cell grown on gallium arsenide (GaAs) or germanium (Ge).

The first solar cell component 102 may include a first side 116 and a second side 118. The first side 116 of the first solar cell component 102 may include the uppermost surface of the adhesive bonded solar cell assembly 100, and may initially receive incoming solar radiation (arrow R). Alternatively, while not shown in the drawings, additional solar cell components may be stacked on top of the first solar cell component 102. The second side 118 of the first solar cell component 102 may be connected to the second solar cell component 104 by way of the adhesive 106, as is described in greater detail herein.

The first conductive interface layer 112 may be positioned on the second side 118 of the first solar cell component 102. The first conductive interface layer 112 may include a metal or a transparent conductive oxide ("TCO"). Examples of suitable transparent conductive oxides include, but are not limited to, zinc oxide (ZnO), cadmium oxide (CdO), indium tin oxide (ITO), tin dioxide (SnO₂), zinc sulfide (ZnS) and zinc selenide (ZnSe).

At this point, those skilled in the art will appreciate that using transparent conductive oxides in the first conductive interface layer 112 may provide dual functionality. As one function, the first conductive interface layer 112 may enhance vertical-direction electrical conductivity (e.g., the layer 112 may have low resistivity) while being substantially optically transparent (e.g., the layer 112 may have high transmission). As another function, the first conductive interface layer 112 may act as an antireflection (AR) coating layer, which may enhance normal incidence transmission of low bandgap light to the second solar cell component 104. High index transparent conductive oxides, such as CdO and ZnO, may be particularly useful as antireflection coatings due to their high index of refraction.

The second solar cell component 104 may be any component, whether active (e.g., contains one or more p-n junctions) or inactive (does not contain a p-n junction), of a solar cell stack. As one general example, the second solar cell component 104 may be a solar subcell, and may include one p-n junction, two p-n junctions or three or more p-n junctions. In other words, the second solar cell component 104 may be a single junction solar cell or a multijunction solar cell. As one specific, non-limiting example, the second solar cell component 104 may be a low bandgap (e.g., bandgaps about 1.1 eV or less) multijunction solar cell grown on silicon (Si) or indium phosphide (InP). As another general example, the second solar cell component 104 may be an inactive handle substrate.

The second solar cell component 104 may include a first side 120 and a second side 122. The first side 120 of the second solar cell component 104 may be connected to the first solar cell component 102 by way of the adhesive 106, as is described in greater detail herein. The second side 122 of the second solar cell component 104 may be the bottom of the adhesive bonded solar cell assembly 100, particularly when the second solar cell component is a handle substrate. While not shown in the drawings, additional solar cell components may be positioned below the second side 122 of the second solar cell component 104.

The second conductive interface layer 114 may be positioned on the first side 120 of the second solar cell component 104. Like the first conductive interface layer 112, the second conductive interface layer 114 may include either a metal or a transparent conductive oxide. Examples of transparent conductive oxides suitable for use in the second conductive interface layer 114 include, but are not limited to, zinc oxide (ZnO), cadmium oxide (CdO), indium tin oxide (ITO), tin dioxide (SnO₂), zinc sulfide (ZnS) and zinc selenide (ZnSe).

The adhesive 106 may be positioned between the first conductive interface layer 112 and the second conductive interface layer 114 to form an adhesive layer 124 that bonds the first solar cell component 102 to the second solar cell component 104. The adhesive 106 may be substantially optically transparent and may have a relatively low index of refraction. For example, the adhesive 106 may have an index of refraction of at most about 1.6, such as about 1.5.

Without being limited to any particular theory, the relatively low index of refraction of the adhesive 106 may create an index contrast with respect to that of high bandgap solar cells (e.g., the first solar cell component 102) to produce high transmission at normal incidence and angle averaged reflectance (e.g., greater than 90 percent) to enhance photon recycling in cells in the first solar cell component 102.

The adhesive 106 may be a transparent adhesive. Examples of adhesives 106 suitable for forming the adhesive layer 124 include, but are not limited to, benzocyclobutene (BCB), SU-8 photoresist, spin-on glass, HD-7010 polyimide (Hitachi DuPont MicroSystems, LLC, of Wilmington, Delaware) and HD-3007 polyimide (Hitachi DuPont MicroSystems, LLC).

The cross-sectional thickness T of the adhesive layer 124 may depend on, among other possible factors, the composition of the adhesive 106 used to form the adhesive layer 124. For example, higher viscosity adhesives 106, such as BCB and SU-8, may result in an adhesive layer 124 having a relatively thick (e.g., about 1 to about 100 microns) cross-sectional thickness T, while lower viscosity adhesives 106, such as spin-on glass, may result in an adhesive layer 124 having a relatively thin (e.g., about 1 micron or less) cross-sectional thickness T.

The contacts 108, 110 may extend through the adhesive layer 124 to electrically couple the first solar cell component 102 to the second solar cell component 104. For example, the contacts 108, 110 may be in electrical contact with both the first and second conductive interface layers 112, 114. Therefore, the contacts 108, 110 may form conduction paths through the adhesive 106 of the adhesive layer 124.

The contacts 108, 110 may be conductive particles. As one non-limiting example, the contacts 108, 110 may be metal particles. As another non-limiting example, the contacts 108, 110 may be carbon nanostructures, such as a carbon nanotubes. As yet another non-limiting example, the contacts 108, 110 may be particles (e.g., polymer spheres) coated with an electrically conductive material (e.g., metal). Use of other conductive particles is also contemplated.

The size of the conductive particles forming the contacts 108, 110 may be dictated by, among other things, the cross-sectional thickness T of the adhesive layer 124. Those skilled in the art will appreciate that the size of the conductive particles forming the contacts 108, 110 may be of a sufficient magnitude to form conduction paths entirely through the adhesive 106 of the adhesive layer 124. For example, when the cross-sectional thickness T of the adhesive layer 124 is about 1 micron, the contacts 108, 110 may have at least one transverse dimension of about 1 micron.

Since each contact 108, 110 forms a conduction path through the adhesive 106 of the adhesive layer 124, the concentration of conductive particles (contacts 108, 110) is relatively low. As such, the presence of the contacts within the adhesive layer 124 does not significantly reduce transmission through the adhesive layer (shadow loss may be relatively low).

In one particular realization, the conductive particles forming the contacts 108, 110 may be pre-mixed (e.g., dispersed) in the adhesive 106. Therefore, the adhesive bonded solar cell assembly 100 may be formed by applying the adhesive 106 (with pre-mixed contacts 108, 110) to the first solar cell component 102 (e.g., over the first conductive interface layer 112) and then positioning the second solar cell component 104 over the first solar cell component 102 such that the adhesive 106 (with pre-mixed contacts 108, 110) is sandwiched between the first and second conductive interface layers 112, 114. Once the adhesive bonded solar cell assembly 100 is assembled, the adhesive 106 may optionally be cured.

While only two contacts 108, 110 are shown in Fig. 1, additional contacts (not shown) may form additional conduction paths through the adhesive layer 124 without departing from the scope of the present disclosure.

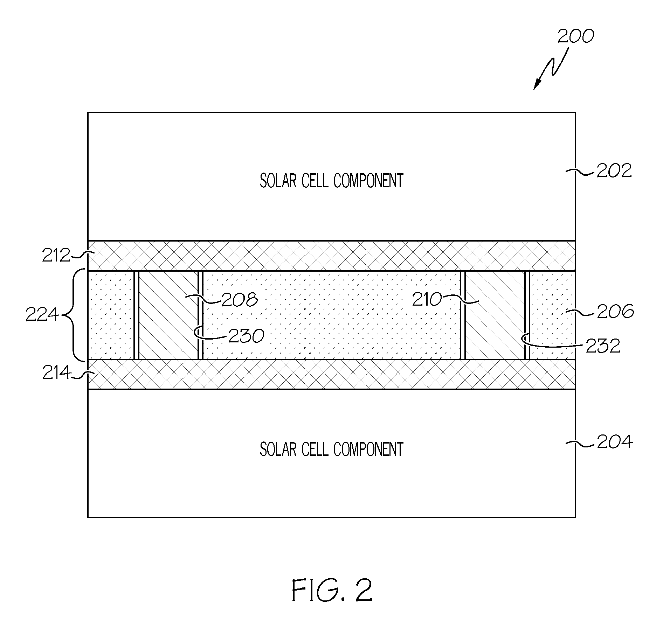

Referring to Fig. 2, another embodiment of the disclosed adhesive bonded solar cell assembly, generally designated 200, may include a first solar cell component 202, a second solar cell component 204, an adhesive 206 for forming an adhesive layer 224, and contacts 208, 210. Optionally, a first conductive interface layer 212 may be applied to the first solar cell component 202 and/or a second conductive interface layer 214 may be applied to the second solar cell component 204.

The first and second solar cell components 202, 204 and the first and second conductive interface layers 212, 214 may be configured as described above in connection with the adhesive bonded solar cell assembly 100 (Fig. 1). Adhesive 206 may also be similar (e.g., a low index of refraction transparent adhesive) to adhesive 106 (Fig. 1) used in connection with the adhesive bonded solar cell assembly 100 (Fig. 1). However, rather than using contacts formed from conductive particles, the contacts 208, 210 of the adhesive bonded solar cell assembly 200 may be formed from a conductive material deposited into channels 230, 232 pre-formed in the adhesive layer 224.

In one particular implementation, the adhesive 206 used to form the adhesive layer 224 may be a photosensitive adhesive. For example, the adhesive 206 may be a photosensitive variant of benzocyclobutene or SU-8. Therefore, the adhesive 206 may be applied to one of the solar cell components 202, 204 and a photomask may be used to pattern channels 230, 232 (e.g., vias) in the adhesive 206. The channels 230, 232 may extend substantially entirely through the adhesive layer 206. Therefore, with the channels 230, 232 pre-formed in the adhesive 206, the conductive material may be deposited into the channels 230, 232. Finally, the remaining solar cell component 202, 204 may be positioned over the adhesive layer 224 such that the adhesive layer 224 is sandwiched between the first and second solar cell components 202, 204. During the bonding process, the conductive material in the channels 230, 232 may flow as it melts or softens and, therefore, may electrically couple the first and second conductive interface layers 212, 214 of the first and second solar cell components 202, 204, and adhesively couple 202, 204. For example, the contacts 208, 210 may be slightly taller than the adhesive 206. When bonded with pressure and temperature the contacts 208, 210 may soften. Under pressure, the contacts 208, 210 may be squeezed down and bulge out such that the flow of the metal would both provide good electrical connection and bring the components into adhesive contact as well.

As one specific, non-limiting example, the conductive material used to form the contacts 208, 210 in the channels 230, 232 in the adhesive 206 may be a metal, such as a low melting point metal (e.g., indium or tin alloys). However, various conductive materials may be used to form the contacts 208, 210. Those skilled in the art will appreciate that selection of a particular conductive material may include consideration of the type of deposition technique being used to form the contacts 208, 210. Examples of suitable deposition techniques for forming the contacts 208, 210 include, but are not limited to, electroplating and vacuum deposition.

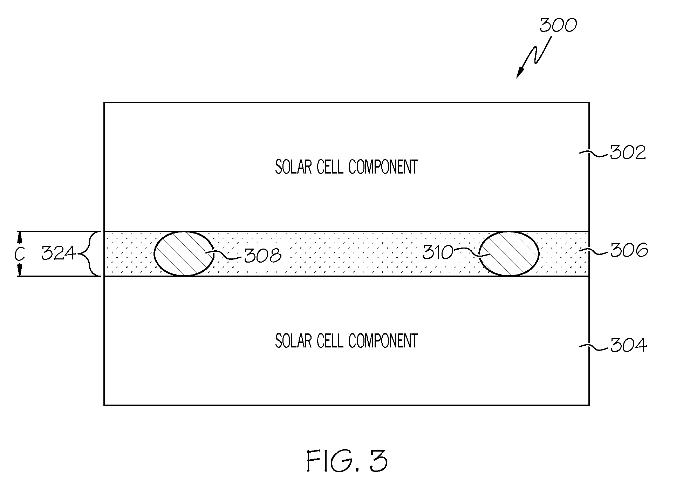

Referring to Fig. 3, yet another embodiment of the disclosed adhesive bonded solar cell assembly, generally designated 300, may include a first solar cell component 302, a second solar cell component 304, an adhesive 306 forming an adhesive layer 324, and contacts 308, 310 extending through the adhesive 306. The adhesive bonded solar cell assembly 300 may be similar to the adhesive bonded solar cell assembly 100 (Fig. 1). However, the adhesive 306 of the adhesive bonded solar cell assembly 300 may be applied as a sufficiently thin adhesive layer 324 such that the adhesive 306 acts an antireflection coating, thereby eliminating the need for the conductive interface layers used in the adhesive bonded solar cell assemblies 100, 200 of Figs. 1 and 2.

The cross-sectional thickness C of the adhesive layer 324 may be controlled to achieve desired antireflection properties. Therefore, the cross-sectional thickness C of the adhesive layer 324 may be selected to optimize the adhesive bonded solar cell assembly 300 for a particular frequency (or range of frequencies) of light.

As one example, the cross-sectional thickness C of the adhesive layer 324 may be at most 1 micron. As another example, the cross-sectional thickness C of the adhesive layer 324 may range from about 100 nm to about 1000 nm. As yet another example, the cross-sectional thickness C of the adhesive layer 324 may range from about 250 nm to about 500 nm.

To achieve such a relatively thin cross-sectional thickness C of the adhesive layer 324, the adhesive 306 may be a low viscosity adhesive. One non-limiting example of a suitable low viscosity adhesive for forming the adhesive layer 324 is spin-on glass.

The disclosed adhesive bonded solar cell assemblies 100, 200, 300 present many advantages over standard multijunction solar cells. Specifically, the use of a transparent adhesive for wafer bonding may facilitate the use of a wider range of lattice-matched materials to be monolithically integrated into a single device. The transparent adhesive also allows for enhanced photon recycling in a multijunction cell stack due to the large index contrast between the adhesive and the semiconductor. Moreover, the use of contacts (e.g., conductive particles or deposited conductive materials) in an adhesive matrix renders the bonding material both transparent and conductive.

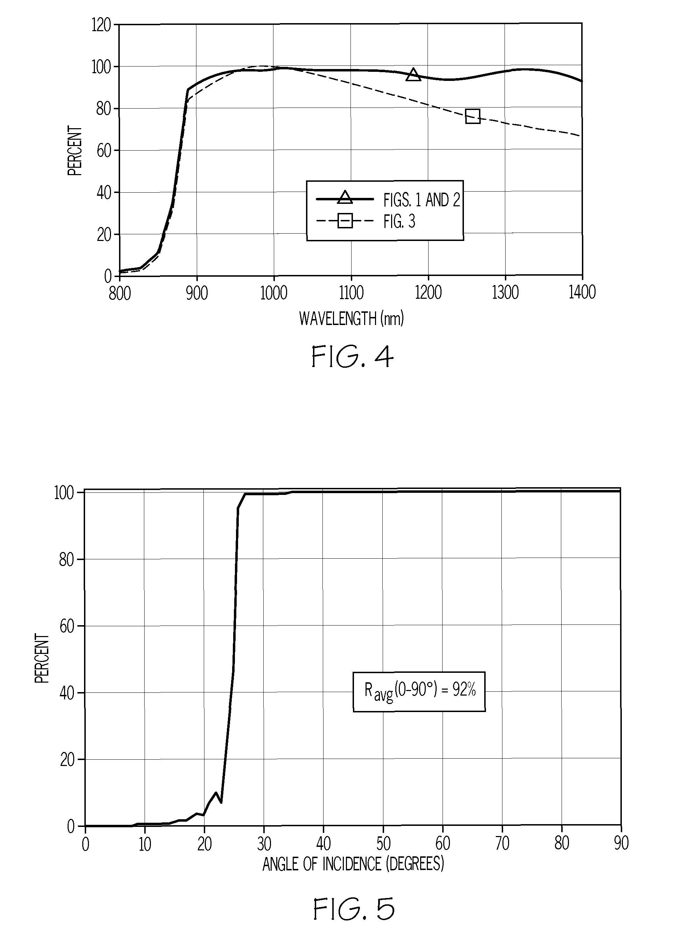

The normal incidence transmission spectrums of the disclosed adhesive bonded solar cell assemblies 100, 200, 300 are shown in Fig. 4. Due to the presence in adhesive bonded solar cell assemblies 100, 200 of conductive interface layers 112, 114, 212, 214 optimized for the near infrared and the low absorption of the proposed transparent adhesives, the average normal incidence transmission from 900 to 1400 nm is greater than 97 percent. Using the adhesive 306 as an AR coating in the adhesive bonded solar cell assembly 300 results in an average transmission of 96 percent over a narrower range of 900 to 1100 nm, which is still adequate for many multijunction solar cell applications.

The low index of refraction (e.g., about 1.5) of the adhesives used in the disclosed adhesive bonded solar cell assemblies 100, 200, 300 allows the adhesive layer to be a reflector of re-radiated photons for the high bandgap junctions above the bond-line. Unlike the incident solar radiation which comes largely at normal incidence, re-radiated photons are emitted over 4π steradian. Therefore an omindirectional mirror is required for effective photon recycling. Fig. 5 shows the reflectance at the bandgap of the re-radiated light of 870 nm (assuming a GaAs cell). The mirror reflectance is near 0 at normal incidence, as would be required for effective transmission of light to lower bandgap cells. However, at angles of incidence greater than the critical angle of 25° for index 1.5 adhesives, the reflectance rises to approximately 100 percent, resulting in angle averaged reflectance of 92 percent. The low critical angle of 25°, which produced the favorable reflectance characteristics shown in Fig. 5, may be a direct result of the large index contrast between the cell and the adhesive. Such a high average reflectance may be sufficient for achieving significant photon recycling and the associated voltage enhancement.

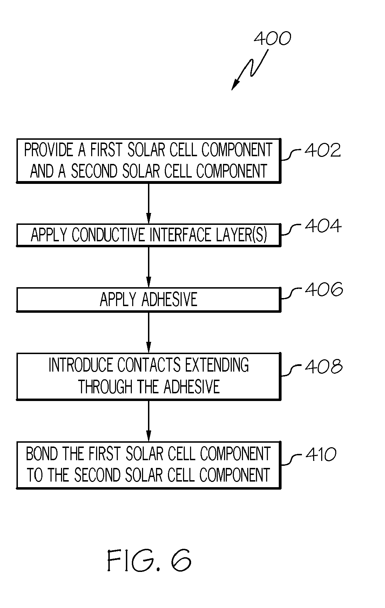

Referring to Fig. 6, also disclosed is a method, generally designated 400, for manufacturing a solar cell assembly. The method 400 may begin a block 402 with the step of providing two solar cell components (or two wafers). As one example, both solar cell components may be active cells. As another example, one solar cell component may be an active cell and the other solar cell component may be a handle substrate.

At block 404, a conductive interface layer may optionally be applied to one or both of the solar cell components to be bonded. The conductive interface layer may be a transparent conductive layer and may function as an antireflection coating layer.

At block 406, an adhesive may be applied to form an adhesive layer between the solar cell components. The adhesive may be a transparent adhesive.

At block 408, contacts may be introduced into the adhesive layer to electrically couple the solar cell components. As one example, the contacts may be conductive particles pre-mixed in the adhesive. As another example, the contacts may be conductive material deposited into through channels formed in the adhesive.

At block 410, the solar cell components may be bonded to each other by way of the adhesive.

Further, the disclosure comprises embodiments according to the following clauses:
Clause 1. A solar cell assembly comprising:
   a first solar cell component (102);
   a second solar cell component (104);
   an adhesive layer (124) positioned between said first solar cell component and said second solar cell component; and
   a contact extending through said adhesive layer to electrically couple said first solar cell component to said second solar cell component.
Clause 2. The solar cell assembly of Clause 1 wherein said first solar cell component (102) comprises a high band gap solar cell.
Clause 3. The solar cell assembly of Clause 1 or 2 wherein said second solar cell component (104) comprises a low bandgap solar cell.
Clause 4. The solar cell assembly of any of Clauses 1 - 3 wherein said second solar cell component (104) comprises a handle substrate.
Clause 5. The solar cell assembly of any of Clauses 1 - 4 wherein said adhesive layer (124) has an index of refraction of at most about 1.6.
Clause 6. The solar cell assembly of any of Clauses 1 - 5 wherein said adhesive layer (124)comprises at least one of benzocyclobutene, SU-8, spin-on glass and polyimide.
Clause 7. The solar cell assembly of any of Clauses 1 - 6 wherein said adhesive layer (124)has a cross-sectional thickness of at least 1 micron.
Clause 8. The solar cell assembly of any of Clauses 1 - 7 wherein said adhesive layer (124) has a cross-sectional thickness of about 100 nanometers to about 1000 nanometers.
Clause 9. The solar cell assembly of any of Clauses 1 - 8 wherein said contact comprises a conductive particle.
Clause 10. The solar cell assembly of Clause 9 wherein said conductive particle comprises at least one of a metal and a carbon nanostructure.
Clause 11. The solar cell assembly of any of Clauses 1 - 10 wherein said adhesive layer (124) defines a channel, and wherein said contact is received in said channel.
Clause 12. The solar cell assembly of any of Clauses 1 - 11 further comprising a conductive interface layer (112) on said first solar cell component (102), wherein said conductive interface layer is positioned between said adhesive layer (124) and said first solar cell component.
Clause 13. The solar cell assembly of Clause 12 wherein said conductive interface layer (112) comprises at least one of a metal and a transparent conductive oxide.
Clause 14. The solar cell assembly of Clause 12 or 13 wherein said conductive interface layer (112) comprises at least one of zinc oxide, cadmium oxide, indium tin oxide, tin dioxide, zinc sulfide and zinc selenide.
Clause 15. The solar cell assembly of any of Clauses 1 - 14 further comprising:
   a first conductive interface layer (112) on said first solar cell component (102),
   wherein said first conductive interface layer is positioned between said adhesive layer (124) and said first solar cell component; and
   a second conductive interface layer (114) on said second solar cell component (104), wherein said second conductive interface layer is positioned between said adhesive layer and said second solar cell component.
Clause 16. The solar cell assembly of Clause 15 comprising a plurality of contacts extending through said adhesive layer, wherein each contact of said plurality of contacts electrically couples said first conductive interface layer (112) to said second conductive interface layer (114).
Clause 17. An assembly comprising:
   a first wafer;
   a second wafer;
   a transparent adhesive positioned between said first wafer and said second wafer to form an adhesive layer, said adhesive having an index of refraction of at most 1.6; and
   at least two contacts, wherein each contact extends through said adhesive layer to electrically couple said first wafer to said second wafer.
Clause 18. A method for manufacturing a solar cell assembly comprising the steps of:
   providing a first solar cell component (102) and a second solar cell component (104);
   forming an adhesive layer (124);
   forming contacts that extend through said adhesive layer; and
   bonding said first solar cell component to said second solar cell component with said adhesive layer.
Clause 19. The method of Clause 18 wherein said contacts comprises conductive particles, and wherein said conductive particles are dispersed in said adhesive layer (124).
Clause 20. The method of Clause 18 or 19 wherein said step of forming contacts comprises:
   forming channels through said adhesive layer; and
   depositing conductive material into said channels.

Although various embodiments of the disclosed adhesive bonded solar cell assembly have been shown and described, modifications may occur to those skilled in the art upon reading the specification. The present application includes such modifications and is limited only by the scope of the claims.

## Claims

1. A solar cell assembly comprising:
a first solar cell component (102);
a second solar cell component (104);
an adhesive layer (124) positioned between said first solar cell component and
said second solar cell component; and
a contact extending through said adhesive layer to electrically couple said first solar cell component to said second solar cell component.

2. The solar cell assembly of Claim 1 wherein said first solar cell component (102) comprises a high band gap solar cell.

3. The solar cell assembly of Claim 1 or 2 wherein said second solar cell component (104) comprises a low bandgap solar cell.

4. The solar cell assembly of any of Claims 1 - 3 wherein said second solar cell component (104) comprises a handle substrate.

5. The solar cell assembly of any of Claims 1 - 4 wherein said adhesive layer (124) has an index of refraction of at most about 1.6.

6. The solar cell assembly of any of Claims 1 - 5 wherein said adhesive layer (124) comprises at least one of benzocyclobutene, SU-8, spin-on glass and polyimide.

7. The solar cell assembly of any of Claims 1 - 6 wherein said adhesive layer (124) has a cross-sectional thickness of at least 1 micron.

8. The solar cell assembly of any of Claims 1 - 7 wherein said adhesive layer (124) has a cross-sectional thickness of about 100 nanometers to about 1000 nanometers.

9. The solar cell assembly of any of Claims 1 - 8 wherein said contact comprises a conductive particle.

10. The solar cell assembly of Claim 9 wherein said conductive particle comprises at least one of a metal and a carbon nanostructure.

11. The solar cell assembly of any of Claims 1 - 10 wherein said adhesive layer (124) defines a channel, and wherein said contact is received in said channel.

12. The solar cell assembly of any of Claims 1 - 11 further comprising a conductive interface layer (112) on said first solar cell component (102), wherein said conductive interface layer is positioned between said adhesive layer (124) and said first solar cell component.

13. The solar cell assembly of Claim 12 wherein said conductive interface layer (112) comprises at least one of a metal and a transparent conductive oxide.

14. The solar cell assembly of Claim 12 or 13 wherein said conductive interface layer (112) comprises at least one of zinc oxide, cadmium oxide, indium tin oxide, tin dioxide, zinc sulfide and zinc selenide.

15. The solar cell assembly of any of Claims 1 - 14 further comprising:
a first conductive interface layer (112) on said first solar cell component (102),
wherein said first conductive interface layer is positioned between said adhesive layer (124) and said first solar cell component; and
a second conductive interface layer (114) on said second solar cell component (104), wherein said second conductive interface layer is positioned between said adhesive layer and said second solar cell component.
